# EUROPÄISCHE PATENTANMELDUNG

(11) **EP 0 551 119 A1**
(43) Veröffentlichungstag der Anmeldung: **14.07.1993**
(21) Anmeldenummer: 93100196.0
(22) Anmeldetag: 08.01.1993
(51) Int. Cl.: G02B 6/12, G02F 1/01

(54) **Verfahren zur Herstellung von nicht linearen optischen Mikrobauelementen**

(30) Priorität: 10.01.1992 DE 4200396
(71) Anmelder: INSTITUT FÜR MIKROTECHNIK MAINZ GmbH, D-55129 Mainz-Hechtsheim (DE)
(72) Erfinder: Ehrfeld, Wolfgang, Prof. Dr., W - 6500 Mainz (DE); Moser, Herbert O.,Dr., W - 7500 Karlsruhe 41 (DE); Müllen, Klaus, Prof. Dr., W - 6500 Mainz (DE); Bubeck, Christoph, Dr., W - 6228 Eltville 5 (DE); Bauer, Hans-Dieter, Dr., W - 6501 Partenheim (DE)
(74) Vertreter: Fuchs, Luderschmidt & Partner Patentanwälte

(57) **Zusammenfassung**

Es wird ein Verfahren zur Herstellung von nicht linearen optischen Mikrobauelementen beschrieben, mit dem der Einsatz bisher noch nicht verwendeter Materialkombinationen ermöglicht werden soll. Mittels der Röntgentiefenlithographie werden nicht nur Wellenleiterstrukturen, sondern auch Mikroküvettenstrukturen hergestellt, in die Material mit nicht linearen optischen Eigenschaften eingebracht wird. Die Mikrostruktur wird als Positivform hergestellt, aus der anschließend mittels Galvanoformung ein Formeinsatz erzeugt wird, der mittels eines aus Polymeren bestehenden Materials abgeformt wird. Nach dem Abformen wird die Mikrostruktur auf ein Substrat aufgebracht und in die Mikroküvettenstruktur wird nicht lineares optisches Material eingefüllt, das gegebenenfalls mittels einer Deckplatte abgedeckt wird.

## Beschreibung

Die Erfindung betrifft ein Verfahren zur Herstellung von nicht linearen optischen Mikrobauelementen, bei dem mittels der Röntgentiefenlithographie aus einem Mehr-Schicht-Resist-Material zunächst eine Wellenleiterstruktur hergestellt wird und die dabei erzeugten Freiräume mit einem Füllmaterial ausgefüllt werden, das der Mantelschicht des Mehr-Schicht-Resist-Materials entspricht. Die Erfindung bezieht sich auch auf Verfahren gemäß dem Oberbegriff von Anspruch 5 und Anspruch 6.

Optische Mikrobauelemente finden Verwendung in optischen Miniaturschaltungen, in denen Lichtsignale erzeugt, durch Wellenleitungen in einer Ebene geführt und verarbeitet sowie nachgewiesen werden können. Die bisher wichtigsten Substratmaterialien für die Herstellung integrierter optischer Bauteile sind Glas, Lithiumniobat und Silizium. Die Klasse der 3-5 Halbleitermaterialien hat insbesondere für die monolithische Integration von passiven Wellenleiterstrukturen und optoelektronischen Bauelementen große Bedeutung gewonnen.

Aus "Technisches Messen, Sonderheft zur Sensor 91", 58 (1991) 4, S. 152 - 157 ist ein Verfahren zur Herstellung optischer Mikrobauelemente bekannt, bei dem von einem Glasstab Wafer abgeschnitten werden. Der nachfolgende Fotolithographieprozess beginnt mit der Herstellung einer geeignet strukturierten Urmaske auf einem Elektronenstrahlschreiber, die im Direktkontaktverfahren auf den zuvor mit Metall und Fotolack beschichteten Glaswafer kopiert wird. Nach der Entwicklung des Lackes und dem Durchätzen der Metallschicht in den offenen Lackbereichen liegt die angestrebte Wellenleiterstruktur als Metallmaske vor. Zur Erzeugung der Wellenleiter werden die Glaswafer in eine heiße Salzschmelze eingebracht, wo Metallionen aus der Schmelze von Konzentrationsgradienten angetrieben durch die Maskenöffnungen in die Glasoberfläche eindringen und dort die Brechzahl erhöhen. Nach Ablösung der Maske werden einzelne Chips aus dem Glaswafer ausgesägt und deren Stirnflächen für die spätere Fasernkopplung poliert. Derart hergestellte Wellenleiter haben ihr Brechzahlmaximum direkt an der Glasoberfläche.

Eine Abschirmung der geführten Lichtwellen gelingt durch das Vergraben der Fremdionen unter die Substratoberfläche in einem zweiten Austauschschritt, der sowohl diffusionskontrolliert (thermisch) als auch driftkontrolliert (feldunterstützt) geführt werden kann.

Zur Herstellung eines nicht linearen optischen Mikrobauelementes auf der Basis von Lithiumniobat wird - wie in "Spektrum der Wissenschaft" Dezember 1986, Seite 116 ff beschrieben - zunächst ein Einkristall aus Lithiumniobat hergestellt, auf dessen Oberfläche ein dünner Titanfilm fotolithographisch mit Hilfe einer Maske aufgebracht wird, um dem Einkristall die gewünschte Wellenleiterstruktur zu geben. Danach wird die gesamte Anordnung auf etwa 1000°C aufgeheizt, so daß das Titan in die äußerste Oberfläche des Lithiumniobats eingebracht wird. Das verbleibende Titan wird weggeätzt.

Der Nachteil dieser Verfahren besteht darin, daß die Auswahl der Materialien für die Herstellung nicht linearer optischer Bauelemente beschränkt ist. Insbesondere die Kombination von optisch linearen und optisch nicht linearen Materialien läßt sich nicht in der gewünschten Vielfalt realisieren. Darüber hinaus sind diese bekannten Verfahren für eine Massenfertigung von nicht linearen optischen Mikrobauelementen zu aufwendig.

Um den Werkstoff der polymeren für den Einsatz von Wellenleitern in Mikrobauelementen zu erschließen, wurde in der Vergangenheit bereits die Röntgentiefenlithographie eingesetzt (siehe z.B. DE PS 36 11 246). Aus einem Mehrschicht-Resist-Material, dessen Kernschicht aus einem lichtleitenden polymeren besteht, können mittels der Röntgentiefenlithographie Wellenleiterstrukturen herausgearbeitet werden, wobei die Freiräume zum Begrenzen der Wellenleiterstruktur mit Mantelmaterial ausgefüllt werden. Die Röntgentiefenlithograpie ermöglicht auch Formeinsätze herzustellen, mittels derer über bekannte Abformtechniken optisch lineare Bauelemente herstellbar sind.

Aufgabe der Erfindung ist es, ein Verfahren bereitzustellen, mit dem nicht lineare optische Mikrobauelemente hergestellt werden können, wobei der Einsatz bisher noch nicht verwendeter Materialkombinationen, insbesondere die Kombination von Polymeren mit linearen optischen Eigenschaften und solchen mit nicht linearen optischen Eigenschaften, ermöglicht werden soll. Außerdem soll das Verfahren wenig aufwendig sein, so daß eine Massenfertigung möglich wird.

Diese Aufgabe wird mit den Verfahren gemäß der Patentansprüche 1, 5 und 6 gelöst. Vorteilhafte Ausgestaltungen sind Gegenstand der Unteransprüche.

Die Erfindung geht von der Erkenntnis aus, daß mittels der Röntgentiefenlithographie nicht nur Wellenleiterstrukturen, sondern auch Mikroküvettenstrukturen herstellbar sind, in die Material mit nicht linearen optischen Eigenschaften eingebracht wird.

Gemäß einer ersten Ausführungsform wird mittels der Röntgentiefenlithographie aus einem Mehrschicht-Resistmaterial zunächst eine Wellenleiterstruktur hergestellt und die dabei erzeugten Freiräume mit einem Füllmaterial ausgefüllt. Dieses Füllmaterial besteht vorzugsweise aus dem gleichen Material wie die Mantelschicht des Mehrschicht-Resistmaterials, so daß die lichtführende Kernschicht bis auf Ein- und Auskoppelstellen allseits von Mantelmaterial umgeben ist. Anschließend wird je nach Ausgestaltung des optischen Mikrobauelementes mindestens im Bereich der Wellenleiterstruktur mindestens eine Mikroküvette herausgearbeitet, in die anschließend Material mit nicht linearen optischen Eigenschaften eingebracht wird.

Vorzugsweise werden bei der Herstellung der Mikroküvettenstruktur gleichzeitig die an der Mikroküvette anschließenden Wellenleiterenden strukturiert. Insbesondere können durch diese Strukturierung die Endflächen an den Lichtwellenleitern gekrümmt ausgebildet oder mit diffraktiven Strukturen versehen werden, mit denen die Energiestromdichte des Lichtes vergrößert oder verkleinert werden kann.

Wenn ein Mehrschicht-Resistmaterial eingesetzt wird, so empfiehlt sich insbesondere ein Dreischicht-Resistmaterial, das gemäß einer vorzugsweisen Ausführungsform aus PMMA mit Mantelschichten aus fluoriertem PMMA besteht.

Gemäß einer weiteren Ausführungsform der Erfindung wird mittels der Röntgentiefenlithographie aus einem Resistmaterial eine Wellenleiterstruktur und mindestens eine Mikroküvettenstruktur aufweisende Mikrostruktur hergestellt, aus der anschließend mittels Galvanoformung ein Formeinsatz erzeugt wird, der mittels eines aus polymeren bestehenden Materials abgeformt wird. Nach dem Abformen wird die Mikrostruktur auf ein Substrat aufgebracht und in die Mikroküvettenstruktur wird optisch nicht lineares Material eingebracht. Die Verwendung eines Formeinsatzes bietet die Möglichkeit, im ersten Verfahrensschritt ein Resistmaterial zu verwenden, das für die Röntgentiefenlithographie geeignet ist und im Abformschritt dann auf ein zweites polymermaterial überzugehen, das sich durch die gewünschten optischen Eigenschaften auszeichnet.

Wenn bereits im ersten Verfahrensschritt ein Resistmaterial verwendet wird, das sowohl für die Röntgentiefenlithographie geeignet ist als auch die gewünschten optischen Eigenschaften besitzt, kann auf die Herstellung eines Formeinsatzes verzichtet werden und in die ausgebildete Mikroküvettenstruktur wird direkt Material mit optisch nicht linearen Eigenschaften eingebracht.

Das nicht lineare optische Material ist vorzugsweise ebenfalls ein polymeres. Geeignete Materialien sind Polyphenylenvinylen (PPV), Polyphenylacetylen (PPA), Polynaphtylenvinylen (PNV).

Das optisch nicht lineare Material kann ein flüssiges Polymeres sein, das nach dem Einbringen in die Mikroküvettenstruktur im flüssigen Zustand verbleibt.

Durch eine Deckschicht wird das flüssige optisch nicht lineare Material verschlossen. Als Deckschicht eignet sich beispielsweise Glas.

Das optisch nicht lineare Material kann nach dem Einbringen in die Mikroküvettenstruktur mittels einer Niedertemperaturplasmabehandlung oder mittels geeigneter Strahlung verfestigt werden. In diesem Fall kann auf eine Deckschicht verzichtet werden.

Anstatt die Mikroküvettenstruktur mit einem flüssigen Polymeren auszufüllen, kann in die Mikroküvettenstruktur auch ein Festkörper mit nicht linearen Eigenschaften eingesetzt werden. Geeignet hierzu sind Kristalle, beispielsweise aus Bariumtitanat. In diesen Fällen kann der nicht lineare optische Festkörper auch zuerst auf das Substrat aufgebracht werden und die nach dem erfindungsgemäßen Verfahren hergestellte Mikroküvettenstruktur anschließend auf das Substrat aufgesetzt werden, so daß diese den nicht linearen optischen Festkörper umgibt.

Vorzugsweise wird die gesamte Mikrostruktur mit einer Deckschicht versehen, die aus Glas besteht oder als Bestandteil Glas aufweist. Sowohl das Substrat als auch die Deckschicht oder Deckplatte besitzen vorzugsweise einen kleineren Brechungsindex als das nicht lineare optische Material bzw. das die Mikroküvettenstruktur bildende Material.

Um gegebenenfalls die optischen Eigenschaften über ein elektrisches Feld beeinflussen zu können, werden im Bereich des nicht linearen optischen Materials Elektroden eingebracht. Dies kann dadurch geschehen, daß auf das Substrat im Bereich des nicht linearen optischen Materials eine Metallschicht für die erste Elektrode und nach dem Einbringen des nicht linearen optischen Materials eine zweite Metallschicht für die zweite Elektrode aufgebracht wird. Eine andere Möglichkeit besteht darin, die Deckschicht vor dem Aufbringen mit einer entsprechenden metallischen Beschichtung zu versehen. Besteht das nicht lineare optische Material aus einem Festkörper, so kann dieser vor dem Einbringen in die Mikroküvettenstruktur mit den entsprechenden elektrisch leitenden Beschichtungen versehen werden.

Da durch den Einsatz der Röngentiefenlithographie der Ausgestaltung der Wellenleiterstrukturen und der Mikroküvettenstrukturen keine Grenzen gesetzt sind, können die unterschiedlichsten Mikrobauelemente, wie Koppler, Gatter oder Schalter hergestellt werden. Darüber hinaus können unterschiedliche Polymermaterialien miteinander kombiniert werden, wodurch aufgrund der besseren optischen Eigenschaften dieser Materialien hinsichtlich ihrer Leistung verbesserte optische Mikrobauelemente hergestellt werden können. Die Fertigungszeiten für die Mikrobauelemente sind kürzer als bei den Verfahren nach dem Stand der Technik. Insbesondere die Verfahrensvariante mittels eines Formeinsatzes eignet sich für die Massenfertigung, da der Formeinsatz mehrfach wiederverwendbar ist, ohne daß Qualitätseinbußen feststellbar sind.

Beispielhafte Ausgestaltungen der Erfindung werden nachfolgend anhand der Zeichnungen näher erläutert, die die Herstellung eines Mikroschalters veranschaulichen.

Es zeigen:
- Figur 1: die perspektivische Darstellung eines Mikrobauelementes in Form eines Schalters,
- Figur 2: einen Schnitt längs der Linie II-II des in Figur 1 gezeigten Schalters,
- Figur 3a -e: die Herstellungsschritte gemäß einer Ausführungsform des Verfahrens bezogen auf einen Schnitt längs der Linie III-III des in Figur 1 gezeigten Schalters und
- Figur 4a-4f: die Herstellungsschritte gemäß einer weiteren Ausführungsform.

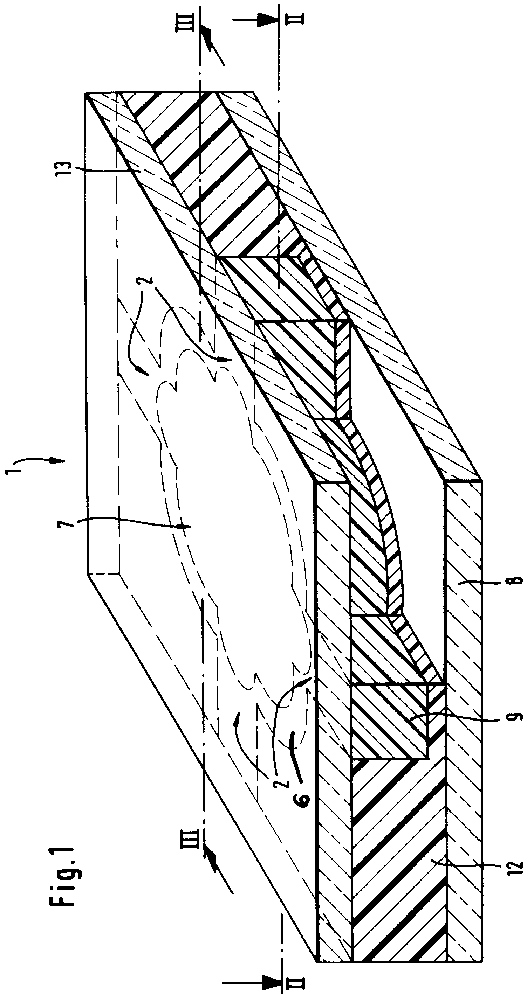

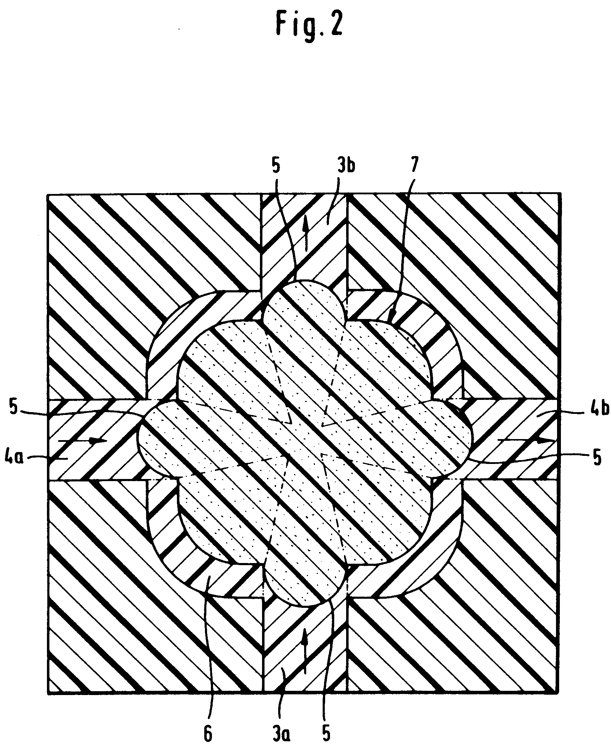

In der Figur 1 ist ein integriertoptischer Mikroschalter 1 perspektivisch dargestellt, wobei im Bereich der vorderen rechten Ecke der mittlere Bereich des Mikrobauelementes 1 zur Verdeutlichung der Mikrostruktur weggelassen wurde. Wie insbesondere auch aus Figur 2 zu entnehmen ist, besitzt der Mikroschalter 1 eine Wellenleiterstruktur 2 in Form von zwei sich kreuzenden Wellenleitern 3a, b, 4a, b. Im Kreuzungsbereich der Wellenleiter 3, 4 befindet sich ein aus dem gleichen Material wie die Wellenleiter 3, 4 gebildeter Zentralbereich 6, in dem eine Mikroküvettenstruktur 7 ausgebildet ist, die mit optisch nicht linearem Material ausgefüllt ist. Die Lichtwellenleiterenden 5, die an die Mikroküvettenstruktur angrenzen, sind gekrümmt ausgeführt, um das Licht - wie in Figur 2 zu sehen ist - zu fokussieren. Über die beispielsweise in den Lichtwellenleiter 4a eingespeiste Lichtintensität kann die Durchlässigkeit des optisch nicht linearen Materials innerhalb der Mikroküvettenstruktur 7 gesteuert werden, so daß das von dem Lichtwellenleiter 3a,b geführte Licht geschaltet werden kann.

Wie in Figur 1 zu sehen ist, befindet sich auf einem Substrat 8 ein die Wellenleiterstruktur 2 und den Zentralbereich 6 bildendes Dreischicht-Resistmaterial, das aus einer Kernschicht 9, einer unteren Mantelschicht 10 und einer oberen Mantelschicht 11 besteht. Die Kernschicht 9 besteht aus pMMA, während die Mantelschichten 10 und 11 ebenso wie das die Wellenleiterstruktur 2 umgebende Füllmaterial 12 aus fluoriertem pMMA bestehen. Die gesamte Wellenleiterstruktur 2 sowie die Mikroküvettenstruktur 7 wird mittels einer Deckschicht 13 abgedeckt, die ebenso wie das Substrat 8 aus Glas bestehen kann.

Die Herstellung eines derartigen optischen Mikrobauelementes 1 wird nachfolgend im einzelnen beschrieben, wobei die Figuren 3a bis 3e die Herstellungsschritte bezogen auf einen Schnitt längs der Linie III-III in Figur 1 verdeutlichen.

Ausgangsmaterial für das Mikrobauelement 1 ist das auf dem Substrat 8 befindliche Drei-Schicht-Resist-Material, das unter Verwendung einer ersten Maske 15, die die Wellenleiterstruktur einschließlich der Struktur des Zentralbereiches aufweist, mit Röntgenstrahlung 14 bestrahlt wird.

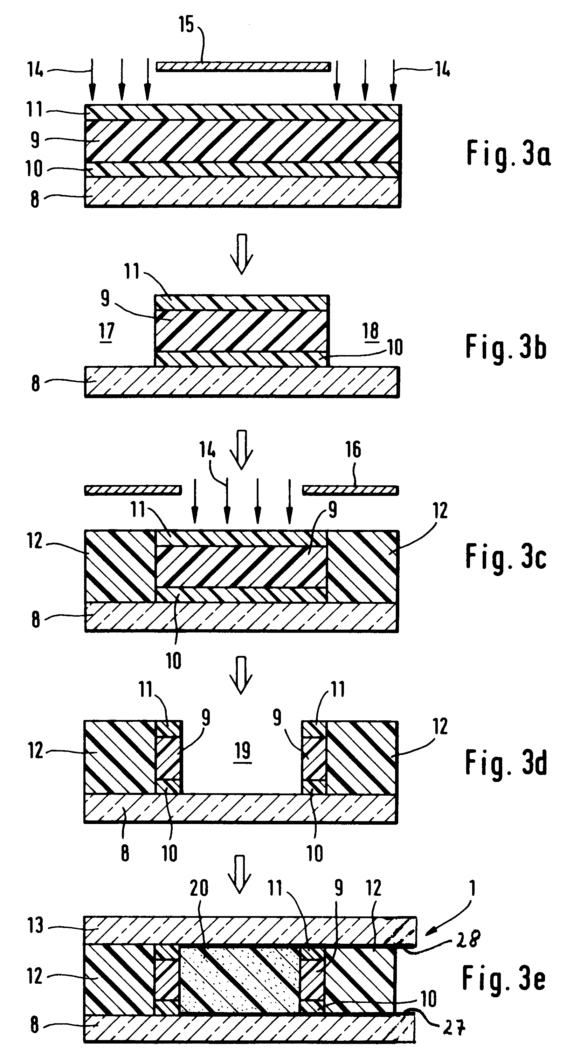

Die bestrahlten Bereiche werden anschließend zur Ausbildung der Freiräume 17 und 18 entfernt (s. Figur 3b) und danach mit Füllmaterial 12 aufgefüllt, das aus dem gleichen Material besteht wie die untere Mantelschicht 10 bzw. die obere Mantelschicht 11. Gegebenenfalls müssen vorher die Oberflächen der Wellenleiterstruktur sowie der Mantelschichten 10 und 11 durch UV-Bestrahlung vernetzt werden. Wie in Figur 3c zu sehen ist, wird das so vorbereitete Element unter Verwendung einer zweiten Maske 16, die die Mikroküvettenstruktur 7 aufweist, ebenfalls mit Röntgenstrahlung 14 bestrahlt.

Wie in der Figur 3d dargestellt ist, werden die bestrahlten Bereiche wiederum entfernt, so daß sich ein weiterer Freiraum 19 ausbildet, der die Mikroküvettenstruktur 7 besitzt. In einem weiteren Arbeitsgang, der in der Figur 3e dargestellt ist, wird dieser Freiraum 19 mit optisch nicht linearem Material gefüllt und anschließend wird die Deckschicht 13 aufgebracht.

In der Figur 3e sind auch die beiden Elektroden 27 und 28 eingezeichnet. Die untere Elektrode 27 ist direkt auf die Oberseite des Substrates 8 als dünne Metallschicht aufgedampft oder aufgesputtert. Falls erforderlich, kann sie durch photolithographische Verfahren strukturiert sein. Die obere Elektrode 28 ist in gleicher Weise auf die Unterseite der Deckschicht oder Deckplatte 13 aufgebracht. Beide Elektroden 27, 28 sind mit Anschlüssen versehen.

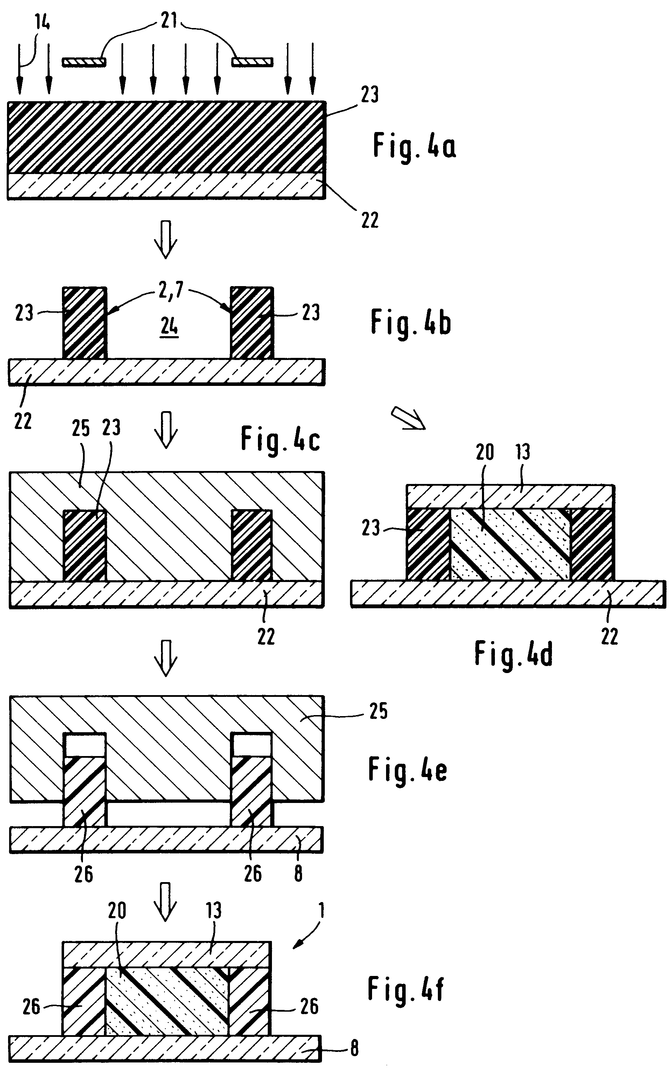

Die Figuren 4a bis 4f zeigen die Herstellungsschritte einer anderen Ausführungsform des erfindungsgemäßen Verfahrens. Auf einem Substrat 22 befindet sich ein Resistmaterial 23, das unter Verwendung einer Maske 21 mit Röntgenstrahlung 14 bestrahlt wird. Die Maske 21 besitzt die Struktur der späteren Wellenleiter und die Mikroküvettenstruktur. Nach dem Bestrahlen und Entfernen der bestrahlten Bereiche bildet das verbleibende Resistmaterial 23 die Wellenleiter- und Mikroküvettenstruktur 2, 7.

Wenn das Resistmaterial 23 bereits ein solches Material ist, das auch die gewünschten optischen Eigenschaften für die Ausbildung von Wellenleitern aufweist, braucht lediglich der Freiraum 24 mit nicht linearem Material 20 ausgefüllt zu werden, um das gewünschte Mikrobauelement 1 fertigzustellen. Je nach dem, ob das nicht lineare Material flüssig oder fest ist, kann die gesamte Struktur noch mit einer Deckschicht 13 versehen werden.

Wenn das Resistmaterial 23 nicht die gewünschten optischen Eigenschaften aufweist, wird mittels der Galvanoformung ein Formeinsatz 25 hergestellt. Dies ist in der Figur 4c schematisch dargestellt. Der Formeinsatz 25 besitzt dann eine Mikrostruktur, die die Wellenleiterstruktur 2 und die Mikroküvettenstruktur 7 umfaßt. Diese Strukturen werden mittels eines weiteren Polymermaterials 26, das die gewünschten optischen Eigenschaften aufweist, abgeformt. Nach Beendigung des in der Figur 4e dargestellten Verfahrensschrittes wird die Mikroküvettenstruktur 7 mit nicht linearem Material 20 aufgefüllt und gegebenenfalls eine Deckschicht 13 aufgebracht.

Um auch hier die abgeformte Struktur zu einem Lichtwellenleiter zu machen, besitzen das Substrat 8 und die Deckplatte 13 einen kleineren Brechungsindex als das Polymermaterial 26. Dies kann z.B. dadurch erreicht werden, daß das Substrat 8 und die Deckplatte 13 jeweils aus zwei Schichten bestehen, wobei z.B. die innere, dem Mikrobauelement zugewandte Schicht aus vorvernetztem fluoriertem pMMA und die äußere Schicht aus Glas oder Phenolharz bestehen kann.

### Bezugszeichenliste:

- 1: Mikrobauelement
- 2: Wellenleiterstruktur
- 3a,b: Wellenleiter
- 4a,b: Wellenleiter
- 5: Wellenleiterenden
- 6: Zentralbereich
- 7: Mikroküvettenstruktur
- 8: Substrat
- 9: Kernschicht
- 10: untere Mantelschicht
- 11: obere Mantelschicht
- 12: Füllmaterial
- 13: Deckschicht
- 14: Röntgenstrahlung
- 15: erste Maske
- 16: zweite Maske
- 17: Freiraum
- 18: Freiraum
- 19: Freiraum
- 20: optisch nicht lineares Material
- 21: Maske
- 22: Substrat
- 23: Resistmaterial
- 24: Freiraum
- 25: Formeinsatz
- 26: Polymermaterial
- 27: untere Elektrode
- 28: obere Elektrode

## Patentansprüche

1. Verfahren zur Herstellung von nicht linearen optischen Mikrobauelementen, bei dem mittels der Röntgentiefenlithographie aus einem Mehr-Schicht-Resist-Material zunächst eine Wellenleiterstruktur hergestellt wird und die dabei erzeugten Freiräume mit einem Füllmaterial ausgefüllt werden, das der Mantelschicht des Mehr-Schicht-Resist-Materials entspricht,
dadurch gekennzeichnet,
daß mittels der Röntgentiefenlithographie anschließend mindestens im Bereich der Wellenleiterstruktur mindestens eine Mikroküvettenstruktur hergestellt wird, in die danach Material mit nicht linearen optischen Eigenschaften eingebracht wird.

2. Verfahren nach Anspruch 1, dadurch gekennzeichnet, daß bei der Herstellung der Mikroküvettenstruktur gleichzeitig die an der Mikroküvette anschließenden Wellenleiterenden strukturiert werden.

3. Verfahren nach Anspruch 1 oder 2, dadurch gekennzeichnet, daß als Mehr-Schicht-Resist-Material ein Drei-Schicht-Resist-Material verwendet wird.

4. Verfahren nach Anspruch 3, dadurch gekennzeichnet, daß für die Mantelschicht des Drei-Schicht-Resist-Materials fluoriertes PMMA und für die Kernschicht PMMA verwendet wird.

5. Verfahren zur Herstellung von nicht linearen optischen Mikrobauelementen, bei dem mittels der Röntgentiefenlithographie aus einem Resist-Material eine Mikrostruktur hergestellt wird, aus der anschließend mittels Galvanoformung ein Formeinsatz erzeugt wird, der mittels eines aus Polymeren bestehenden Materials abgeformt wird, dadurch gekennzeichnet,
daß aus dem Resist-Material eine Wellenleiterstruktur und mindestens eine Mikroküvettenstruktur aufweisende Mikrostruktur als Positivform hergestellt wird,
daß nach dem Abformen die Mikrostruktur auf ein Substrat aufgebracht wird, und daß in die Mikroküvettenstruktur optisch nicht lineares Material eingebracht wird.

6. Verfahren zur Herstellung von aktiven optischen Mikrobauelementen, bei dem mittels der Röntgentiefenlithographie aus einem Resist-Material eine Mikrostruktur hergestellt wird, dadurch gekennzeichnet,
daß aus dem Resist-Material eine Wellenleiterstrukturen und mindestens eine Mikroküvettenstruktur aufweisende Mikrostruktur hergestellt wird und
daß in die Mikroküvettenstruktur optisch nicht lineares Material eingebracht wird.

7. Verfahren nach einem der Ansprüche 1 bis 6, dadurch gekennzeichnet, daß als nicht lineares optisches Material Polymere verwendet werden.

8. Verfahren nach einem der Ansprüche 1 bis 7, dadurch gekennzeichnet, daß zumindest im Bereich des nicht linearen optischen Materials eine Deckschicht aufgebracht wird.

9. Verfahren nach einem der Ansprüche 1 bis 8, dadurch gekennzeichnet, daß das nicht lineare optische Material nach dem Einbringen in die Mikroküvetten-Struktur flüssig bleibt und durch eine Deckschicht verschlossen wird.

10. Verfahren nach Anspruch 9, dadurch gekennzeichnet, daß eine Deckschicht aus Glas verwendet wird.

11. Verfahren nach einem der Ansprüche 1 bis 10, dadurch gekennzeichnet, daß das nicht lineare Material nach Einbringen in die Mikroküvettenstruktur mittels einer Niedertemperaturplasmabehandlung oder mittels geeigneter Strahlung verfestigt wird.

12. Verfahren nach einem der Ansprüche 1 bis 11, dadurch gekennzeichnet, daß das nicht lineare optische Material mit Elektroden versehen wird.
